# EUROPÄISCHE PATENTSCHRIFT

(11) **EP 2 018 793 B1**
(45) Veröffentlichungstag und Bekanntmachung des Hinweises auf die Patenterteilung: **04.07.2018**
(21) Anmeldenummer: 07720106.9
(22) Anmeldetag: 30.04.2007
(51) Int. Cl.: H05B 33/10, H05B 33/12, H01L 23/32, H01L 51/00

(54) **VERFAHREN ZUM HERSTELLEN EINER ELEKTROLUMINESZENZANORDNUNG SOWIE NACH EINEM SOLCHEN VERFAHREN HERGESTELLTE ELEKTROLUMINESZENZANORDNUNG**
METHOD FOR THE PRODUCTION OF AN ELECTROLUMINESCENCE APPARATUS AND AN ELECTROLUMINESCENCE APPARATUS PRODUCED ACCORDING TO SAID METHOD
PROCÉDÉ DE FABRICATION D'UN ENSEMBLE ÉLECTROLUMINESCENT ET ENSEMBLE ÉLECTROLUMINESCENT FABRIQUÉ SELON UN TEL PROCÉDÉ

(30) Priorität: 02.05.2006 CH 715062006
(43) Veröffentlichungstag der Anmeldung: 28.01.2009
(73) Patentinhaber: SST Smart Surface Technology AG, 9056 Gais (CH)
(72) Erfinder: KNECHTLI, Heidi, 9424 Rheineck (CH); ENZ, Emil, 9056 Gais (CH)
(74) Vertreter: Rentsch Partner AG
(86) Internationale Anmeldenummer: PCT/CH2007/000209
(87) Internationale Veröffentlichungsnummer: WO 2007/124611

(56) Entgegenhaltungen:
- WO-A-98/30069
- WO-A2-02/103718
- US-A- 5 830 028
- US-A1- 2004 232 943
- US-A1- 2005 260 413

## Beschreibung

### TECHNISCHES GEBIET

Die vorliegende Erfindung bezieht sich auf das Gebiet der Elektrolumineszenzlampen bzw. -anzeigen, die nach dem Prinzip eines elektrischen Kondensators aufgebaut sind. Sie betrifft ein Verfahren zur Herstellung einer Lumineszenzanordnung gemäss dem Oberbegriff des Anspruchs 1.

### STAND DER TECHNIK

Elektrolumineszenzlampen bzw. -anzeigen, die nach dem Prinzip eines elektrischen Kondensators aufgebaut sind und eine zwischen zwei Elektroden angeordnete, durch Wechselspannung von z.B. 100 V zum Leuchten anregbare, dielektrische Zwischenschicht aufweisen, sind seit längerem bekannt und finden aufgrund ihres einfachen Aufbaus und der vielfältigen Einsatzmöglichkeiten zunehmend im Alltag Anwendung. Sie können beispielsweise zu Beleuchtungszwecken in Autos eingesetzt werden (siehe z.B. die WO-A1-03/037039 oder die US-A1-2006/0061138), oder für beleuchtete Aufkleber ("labels") (siehe z.B. die US-B1-6,624,569), oder als auf ein Gewebe oder dgl. auftragbare, biegsame Beleuchtung (siehe z.B. die WO-A1-98/30069).

Üblicherweise wird die optisch eigentlich aktive Schichtenfolge aus Rückelektrode, Zwischenschicht und (transparenter) Frontelektrode auf ein mechanisch stabiles Substrat, z.B. eine biegsame Folie, aufgebracht und zusammen mit dem Substrat eingesetzt (siehe z.B. die US-A-5,019,748 oder die US-A1-2002/0190636): Wird die auf ein Substrat aufgebrachte Schichtenfolge bei der Anwendung in einem Tiefziehprozess mit anschliessendem Anspritzen dreidimensional verformt, wie dies in den o.g. Druckschriften WO-A1-03/037039 und US-A1-2006/0061138 beschrieben ist, müssen hinsichtlich der dabei auftretenden Biegeradien der Anordnung Grenzen eingehalten werden, um eine Beschädigung der Schichten und damit eine Verschlechterung oder sogar einen partiellen oder vollständigen Ausfall der Beleuchtungsfunktion zu verhindern. Da die Schichtenfolge auf ein Substrat aufgebracht ist, verschiebt sich beim Biegen der Gesamtanordnung aus optisch aktiver Schichtenfolge und Substrat die neutrale Ebene, die weder gedehnt noch gestaucht wird, zum Substrat hin, so dass die am weitesten vom Substrat entfernten Schichten der Schichtenfolge beim Biegen stärker belastet werden.

Weiterhin beschränkt das Substrat die Einsatzmöglichkeiten der Elektrolumineszenzanordnung, weil es eine zusätzliche Schicht und ein zusätzliches Material in die Anordnung einbringt, auf die bei der Anwendung Rücksicht genommen werden muss.

In der bereits genannten WO-A1-98/30069 ist eine elastomere ElektrolumineszenzLampe vorgeschlagen worden, bei der zunächst die lampenförmige Elektrolumineszenzanordnung auf einem Transferpapier ("transfer release paper" 102) hergestellt und dann auf der Oberseite mit einer Klebeschicht ("adhesive layer" 116) versehen wird. Die Elektrolumineszenzanordnung kann dann entweder direkt von dem Transferpapier in eine Anwendung transferiert und integriert werden, oder es wird zunächst auf die Oberseite eine Klebeschicht aufgebracht, die z.B. einen Heisskleber enthält, und die für die dauerhafte flächige Haftung der Elektrolumineszenzanordnung auf Stoffen, Bekleidungsstücken oder dgl. sorgt. Die Elektrolumineszenzanordnung umfasst hierbei jedoch nicht nur die optisch aktive Schichtenfolge aus transparenter Frontelektrode (ITO layer 106), Elektrolumineszenzschicht (108), dielektrischer Schicht (110) und Rückelektrode (112), sondern auch eine geschlossene Umhüllung, die aus zwei vergleichsweise dicken Umhüllungsschichten (104, 114) besteht. Die untere Umhüllungsschicht (104) wird aus Polyurethan durch mehrmaliges Auftragen (Aufdrucken) erzeugt, so dass sie nach dem Aushärten eine monolithische Schichtdicke erreicht und damit als mechanisch stabiles Substrat wirkt. Dasselbe gilt für die obere Umhüllungsschicht (114). Insgesamt ergibt sich eine vergleichsweise dicke monolithische Umhüllung, die der Elektrolumineszenzanordnung unabhängig von dem Transferpapier eine mechanische Eigenstabilität gibt, andererseits jedoch die Anwendungsmöglichkeiten einschränkt.

Aus der WO-A1-97/26673 ist weiterhin ein Verfahren zur Herstellung einer Elektrolumineszenzlampe bekannt, bei der separat ein mit einer durchsichtigen Leitschicht beschichtetes, durchsichtiges Substrat und ein zeitweiliges Substrat bereitgestellt werden, dann mit einer Rollenauftragstechnik auf das zeitweilige Substrat nacheinander eine Rückelektrode, eine dielektrische Schicht und eine Phosphorschicht aufgetragen werden, und schliesslich beide Teile mit der Phosphorschicht auf der Leitschicht zusammenlaminiert werden. Durch die Aufteilung des Herstellungsprozesses auf zwei Substrate kann die Auftragung der Schichten einerseits vereinfacht werden. Andererseits wird jedoch die Auswahl an endgültigen Substraten stark eingeschränkt, weil diese geeignet sein müssen, eine Elektrode (hier die durchsichtige Frontelektrode) zu tragen.

### DARSTELLUNG DER ERFINDUNG

Es ist daher Aufgabe der Erfindung, ein Verfahren zur Herstellung einer Elektrolumineszenzanordnung, anzugeben, welches die Nachteile bekannter Verfahren vermeidet und sich insbesondere durch besondere Einfachheit auszeichnet, und einen deutlich verbreiterten Anwendungsbereich erschliesst.

Die Aufgabe wird durch die Gesamtheit der Merkmale des Anspruchs 1 gelöst. Der Kern der Erfindung besteht darin, auf einem Hilfsträger mit einfachsten Mitteln eine auf das absolut Notwendige reduzierte, funktionsfähige Schichtenfolge aus Rückelektrode, optisch aktivem Dielektrikum und Frontelektrode zu erzeugen, die wegen ihrer geringen Dicke keine Eigenstabilität aufweist und nur durch einen direkten Transfer vom Hilfsträger auf den endgültigen Einsatzort gebracht werden kann. Insbesondere kann dabei im zweiten Schritt der darin gebildete Verbund aus der Schichtenfolge und dem Substrat gleichzeitig dreidimensional verformt werden.

Eine Ausgestaltung des Verfahrens nach der Erfindung ist dadurch gekennzeichnet, dass innerhalb des ersten Schritts nacheinander die erste Elektrodenschicht, die Zwischenschicht und die zweite Elektrodenschicht auf den Hilfsträger aufgebracht werden, dass die einzelnen Schichten der Schichtenfolge mittels eines Druckverfahrens auf den Hilfsträger aufgedruckt werden, und dass die Schichten der Schichtenfolge mittels Siebdruck auf den Hilfsträger aufgedruckt werden.

Eine andere Ausgestaltung zeichnet sich dadurch aus, dass zur Bildung der optisch aktiven, dielektrischen Zwischenschicht wenigstens eine dielektrische Schicht und eine Elektrolumineszenzschicht in dieser oder umgekehrter Reihenfolge auf den Hilfsträger aufgebracht werden.

Alternativ dazu kann zur Bildung der optisch aktiven, dielektrischen Zwischenschicht ein dielektrisches Material mit darin eingebetteten, zur Elektrolumineszenz anregbaren Einschlüssen auf den Hilfsträger aufgebracht werden.

Gemäss einer bevorzugten Ausgestaltung der Erfindung wird zumindest eine der beiden Elektrodenschichten als optisch transparente Elektrode ausgebildet wobei entweder die erste Elektrodenschicht oder die zweite Elektrodenschicht als optisch. transparente Elektrode ausgebildet wird.

Gemäss einer weiteren Ausgestaltung kann vor dem Aufbringen der Schichtenfolge mit den zwei Elektrodenschichten und der dazwischen liegenden Zwischenschicht auf den Hilfsträger zunächst eine zusätzliche Schicht aufgebracht werden, welche die unterschiedlichsten Aufgaben erfüllen kann. Insbesondere kann die zusätzliche Schicht eine Isolier- und/oder Haftschicht sein.

Es kann als zusätzliche Schicht auch eine Trennschicht aufgebracht werden, welche die Trennung von Schichtenfolge und Hilfsträger ermöglicht bzw. erleichtert.

Insbesondere kann die Trennschicht beim Ablösen des Hilfsträgers auf dem Hilfsträger verbleiben.

Es ist aber auch denkbar, dass die Trennschicht als elektrisch isolierende Schicht ausgebildet ist und beim Ablösen des Hilfsträgers als isolierende Abdeckung auf der ersten Elektrodenschicht verbleibt.

Weiterhin ist es denkbar, dass zur Isolierung und/oder besseren Haftung der Schichtenfolge auf dem Substrat zwischen der Schichtenfolge und dem Substrat eine Isolier-/Haftschicht eingebracht wird, wobei die Isolier-/Haftschicht vorzugsweise vor dem zweiten Schritt auf die zweite Elektrodenschicht aufgebracht wird.

Gemäss einer anderen Ausgestaltung der Erfindung werden zum Aufbau wenigstens einer der Elektrodenschichten leitfähige organische Materialien, insbesondere leitfähige Polymere, verwendet.

Es ist aber auch denkbar, dass zum Aufbau wenigstens einer der Elektrodenschichten leitfähige anorganische Stoffe aus der Reihe Silber, Kohlenstoff, Indium-Zinn-Oxid (ITO), Pigmente auf Glimmerbasis mit leitfähiger Umhüllung (Minatec®), verwendet werden.

Als Substrat wird vorzugsweise ein Material aus der Reihe Holz, Gewebe, insbesondere Wolle oder Baumwolle, Metall, Kunststoff, insbesondere PVC, Polyamid, Polyester, Polystyren, PP; PUR, PE, Polycarbonat, ABS, PMMA, Gummi, Papier, Leder, Kork und Glas verwendet.

Eine bevorzugte Ausgestaltung der erfindungsgemässen Elektrolumineszenzanordnung ist dadurch gekennzeichnet, dass die Gesamtdicke der Schichtenfolge etwa 50 µm beträgt.

Eine besonders hohe Dehnfähigkeit der erfindungsgemässen Elektrolumineszenzanordnung und damit eine weiter verbesserte Flexibilität und Sicherheit in der Anwendung lässt sich erreichen, wenn gemäss einer besonders bevorzugten Ausgestaltung die Schichten der Schichtenfolge jeweils ein hochflexibles Bindemittel, insbesondere auf Basis PU, PMMA, PVA, enthalten.

Gemäss einer Weiterbildung ist auf wenigstens einer Seite der Schichtenfolge eine zusätzliche Schicht mit Isolier-und/oder Hafteigenschaften angeordnet.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in mehreren Teilfiguren 1(a) bis 1(g) verschiedene Schritte bei einem Herstellungsverfahren gemäss einem ersten Ausführungsbeispiel der Erfindung;
- Fig. 2: in mehreren Teilfiguren 2(a) bis 2(g) verschiedene Schritte bei einem Herstellungsverfahren gemäss einem zweiten Ausführungsbeispiel der Erfindung, wobei die Teilfiguren 2(f) und 2(g) sich auf alternative Ausgestaltungen beziehen;
- Fig. 3: in mehreren Teilfiguren 3(a) bis 1(f) verschiedene Schritte bei einem Herstellungsverfahren gemäss einem dritten Ausführungsbeispiel der Erfindung; und
- Fig. 4: in mehreren Teilfiguren 4(a) bis 4(d) verschiedene Schritte bei einem Herstellungsverfahren gemäss einem weiteren Ausführungsbeispiel der Erfindung, bei dem zur besseren Kontaktierung eine Verstärkung der transparenten Elektrodenschicht vorgesehen ist.

### WEGE ZUR AUSFÜHRUNG DER ERFINDUNG

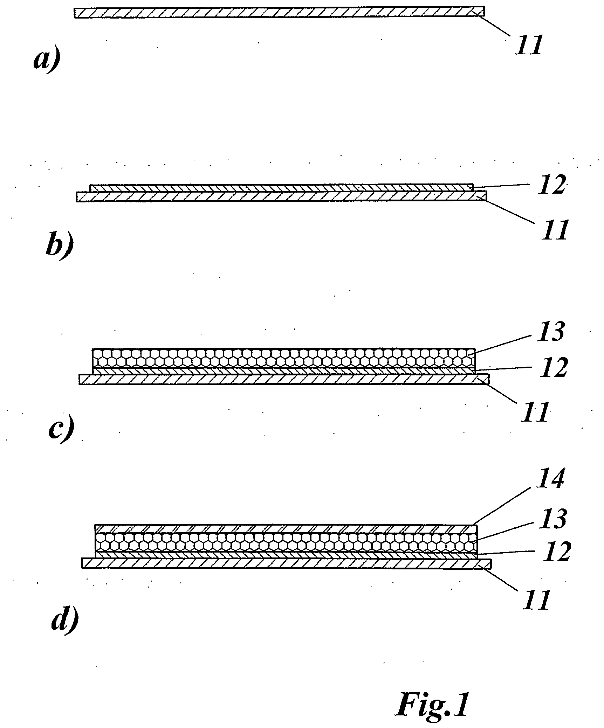

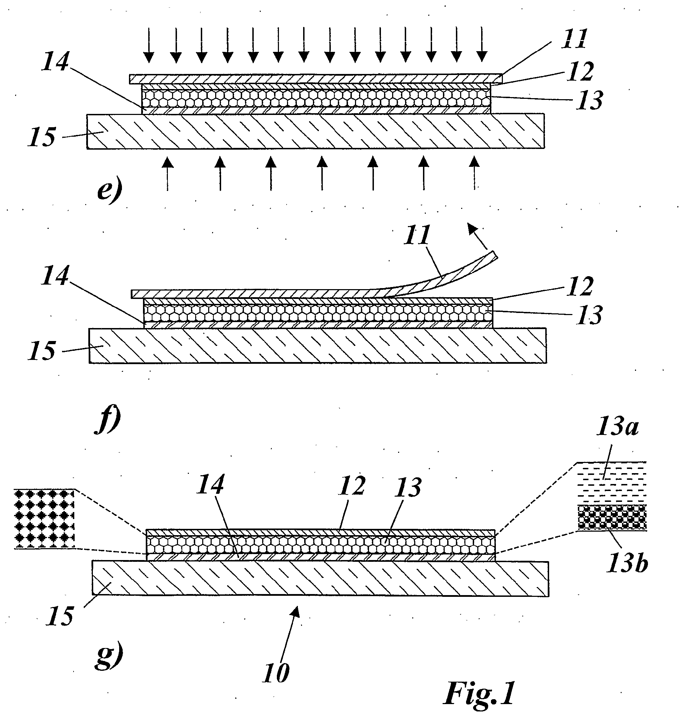

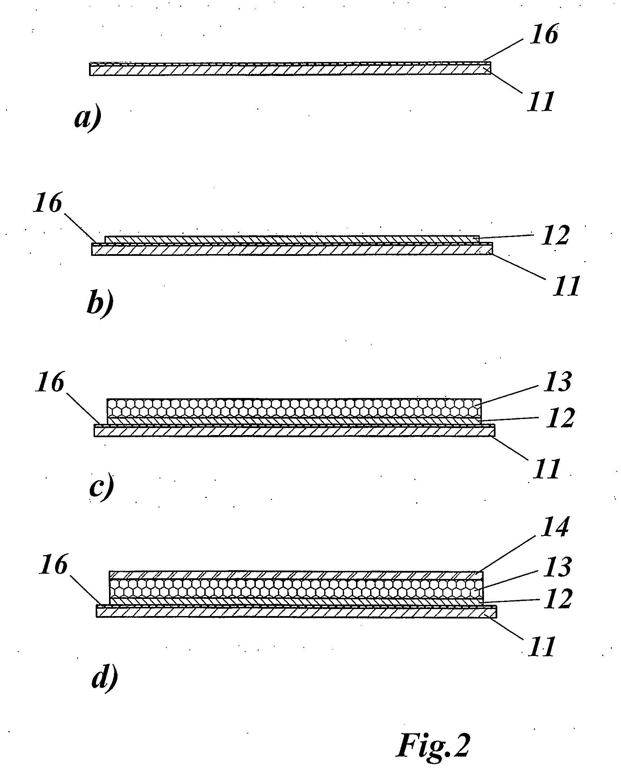

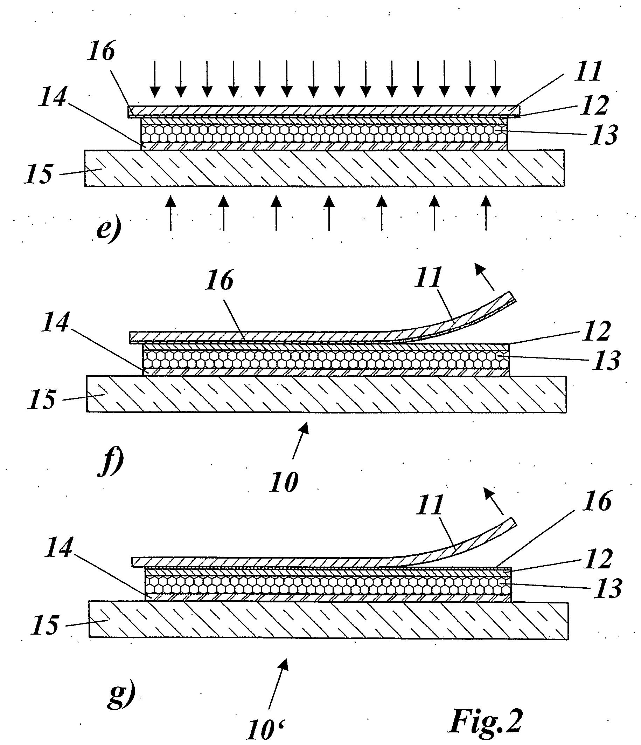

In Fig. 1 sind in mehreren vereinfachten Teilfiguren 1(a) bis 1(g) verschiedene Schritte bei einem Herstellungsverfahren gemäss einem ersten Ausführungsbeispiel der Erfindung wiedergegeben. Das in Fig. 1 gezeigte Verfahren geht aus von einem (insbesondere folienartigen) Hilfsträger 11 mit Antihafteigenschaften, wie z.B. einem gewöhnlichen Backpapier oder einem leicht silikonisierten Papier, wie es als Träger von selbstklebenden Etiketten Verwendung findet (Fig. 1a). Selbstverständlich können auch andere Arten von Hilfsträgern eingesetzt werden, sofern sie entweder selbst Antihafteigenschaften aufweisen, oder - wie weiter unten im Zusammenhang mit Fig. 2 erläutert - mit einer geeigneten Trennschicht beschichtbar sind. Denkbar sind beispielsweise Hilfsträger 11 auf der Basis von PUR, EP, Co-Polyamid, TPU, Co-Polyester, PP, PE oder EVA.

Auf den Hilfsträger 11 wird in einem ersten Schritt, insbesondere mittels Siebdruck, eine erste Elektrodenschicht 12 aufgebracht (Fig. 1b). Die Art der ersten Elektrodenschicht 12 richtet sich danach, ob die Elektrolumineszenzanordnung (10 in Fig. 1g) von der Vorderseite (Leuchtseite) oder von der Rückseite her aufgebaut wird. Wird die Elektrolumineszenzanordnung 10 von der Vorderseite her aufgebaut, muss die erste Elektrodenschicht 12 optisch transparent sein. Hierfür steht eine Vielzahl von unterschiedlichen Materialien und Möglichkeiten zur Verfügung. Als transparente Elektrodenmaterialien kommen organische und anorganische Systeme in Betracht:
- Organisch, auf Wasserbasis: Das unter dem Markennamen Baytron® P bekannte intrinsisch leitfähige Polymer (ICP) mit Bindemitteln auf Basis von PU/Polyester/Polyether;
- Organisch, auf Lösungsmittelbasis: Das unter dem Namen Ormecon® bekannte intrinsisch leitfähige Polymer (ICP) auf Basis von Polyanilin;
- Anorganisch: Indium-Zinn-Oxid (ITO); .
- Anorganisch: Das unter dem Markennamen Minatec® bekannte Lackpigment auf der Basis von Glimmerflocken, die mit einer elektrisch leitenden anorganischen Schicht aus einer Mischung von Metalloxiden überzogen sind.

Wird die Elektrolumineszenzanordnung 10 von der Rückseite her aufgebaut, kann die erste Elektrodenschicht 12 lichtundurchlässig sein. Als Elektrodenmaterial kommt in diesem Fall Ag oder C in Betracht, die beispielsweise als pulverförmige Füller in einem geeigneten Bindemittel dispergiert sind.

Wenn die erste Elektrodenschicht 12 getrocknet ist bzw. abgebunden hat, kann, ebenfalls mittels Siebdruck, die optisch aktive, dielektrische Zwischenschicht 13 aufgebracht werden (Fig. 1c). Die Zwischenschicht 13, welche das eigentliche Elektrolumineszenzmaterial, z.B. dotierte Zinksulfidkristalle, enthält, kann als eine homogene Schicht ausgebildet sein, wie dies in der vergrösserten Darstellung auf der linken Seite der Fig. 1g angedeutet ist. Die Kristallkörner sind in diesem Fall homogen in eine Matrix aus dielektrischem Material eingebettet. Die Zwischenschicht 13 kann aber auch eine Schichtenfolge aus wenigstens einer separaten dielektrischen Schicht 13a (ohne Elektrolumineszenzmaterial) und einer Elektrolumineszenzschicht 13b sein, wie dies in der vergrösserten Darstellung auf der rechten Seite der Fig.1g angedeutet ist. Die Reihenfolge der beiden Schichten kann dabei wechseln.

Wenn die Zwischenschicht 13 fertiggestellt ist, kann mittels Siebdruck als nächste Schicht die zweite Elektrodenschicht 14 aufgebracht werden (Fig. 1d). Stellt die zweite Elektrodenschicht 14 die Rückelektrode dar, kann hierfür insbesondere Ag verwendet werden. Handelt es sich dagegen um die Frontelektrode, müssen entsprechend die o.g. optisch transparenten Materialien zum Einsatz kommen. Es ist im übrigen auch denkbar, beide Elektrodenschichten 12, 14 optisch transparent auszubilden, so dass die Elektrolumineszenzanordnung 10 prinzipiell zu beiden Seiten Licht abstrahlt.

Die fertige Schichtenfolge 12, 13, 14 auf dem Hilfsträger 11 kann nun an ihrem Einsatzort auf ein dort bereitgestelltes (stabiles) Substrat 15 übertragen werden (Fig. 1e). Hier wird der Schichtverbund 11,..,14 aus Fig. 1d umgekehrt, d.h. mit der zweiten Elektrodenschicht 14 zuerst, auf das Substrat 15 gelegt und dann mit dem Substrat 15 unter Einwirkung von Druck und/oder Wärme (in Fig. 1e durch die Pfeile angedeutet) flächig verbunden. In Fig. 1 ist das Substrat 15 als einfache ebene Platte gezeichnet. Selbstverständlich kann das Substrat 15 auch räumlich konturiert sein, so dass sich der Schichtverbund 11,..,14 dreidimensional verformen und anpassen muss. Desgleichen kann aber auch beim Verbinden des Schichtverbundes 11,..,14 und des Substrats 15 gleichzeitig beiden eine dreidimensionale Form oder Kontur aufgeprägt werden, um so aus den zunächst ebenen Schichten 12,..,14 bzw. dem zunächst ebenen Substrat 15 eine räumlich konturierte bzw. verformte Elektrolumineszenzanordnung zu erzeugen. Die sehr geringe Dicke der Schichtenfolge 12,..,14, die weniger als 100 µm, vorzugsweise etwa 50 µm, beträgt, trägt wesentlich dazu bei, dass die Schichtenfolge ausserordentlich biegsam und anpassungsfähig ist und sogar vergleichsweise weit gedehnt werden kann, ohne die Leuchtfunktion zu verschlechtern oder ganz einzubüssen.

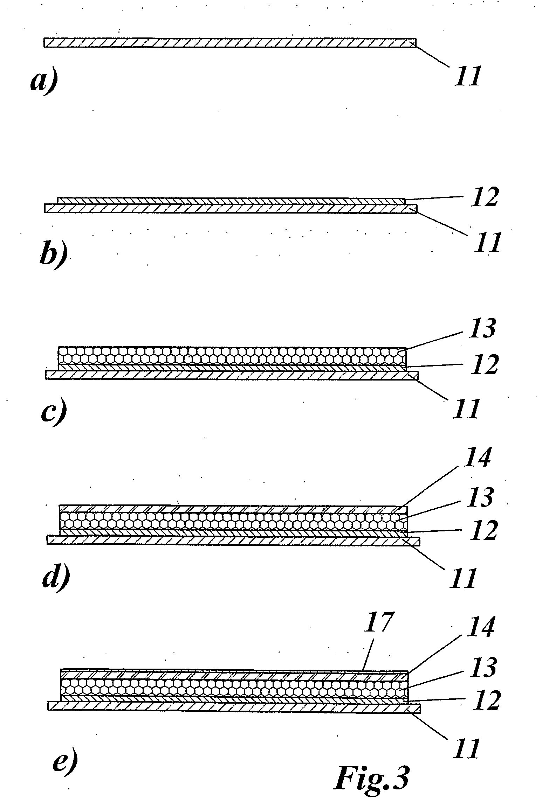

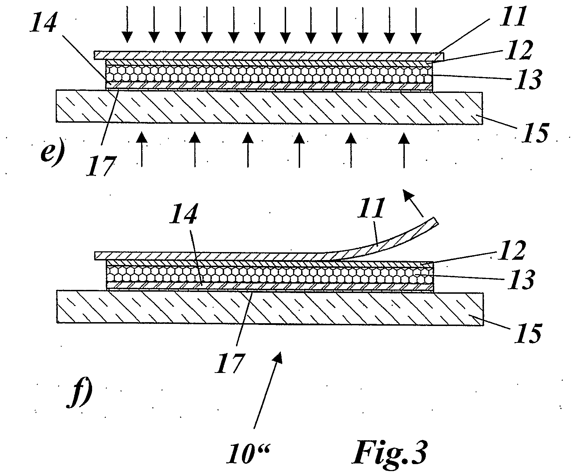

Die Schichtenfolge 12,..,14 kann als ganzes oder auch teilweise auf Substrate 15 aus verschiedenen Materialien übertragen werden. Hierbei kommen Stoffe (Gewebe), Holz, Metall, insbesondere Aluminium, Papier, Leder, Kork, Glas usw. in Betracht. Wenn sich dabei kein eigenständiger Verbund zwischen der zweiten Elektrodenschicht 14 und dem Substrat bilden lässt, muss gemäss Fig. 3 eine zusätzliche Isolier-/Haftschicht 17 zwischen beiden vorgesehen werden. Verbunde sind möglich zu Substraten 15 aus PVC, Polyamid, Polyester, Polystyren, PP, PUR, PE, Polyamid, Poycarbonat, ABS, PMMA, PS, Gummi, Neopren, Cellulose Acetat, Aramid, Wolle, Baumwolle.

Nachdem die Schichtenfolge 12,..,14 mit dem Substrat 15 fest haftend verbunden ist, kann der Hilfsträger 11 abgenommen werden (Fig. 1f), so dass das Substrat 15 mit der darauf haftenden Schichtenfolge 12,..,14 übrigbleibt (Fig. 1g). Die Kontaktierung der beiden Elektrodenschichten 12 und 14 kann in an sich bekannter Weise erfolgen und wird hier nicht weiter beschrieben. Ist die zweite Elektrodenschicht 14 die (optisch transparente) Frontelektrode, fällt das Licht durch das Substrat 15, sofern dieses eine entsprechende Durchlässigkeit aufweist. So ist es beispielsweise denkbar, als Substrat 15 ein dünnes Holzfurnier zu verwenden, das aufgrund seiner Dicke durchscheinend ist und entsprechend von hinten beleuchtet werden kann. Hierdurch können z.B. bei Holzeinlagen im Innenraum eines Autos attraktive Beleuchtungseffekte erzeugt werden.

Wenn die Elektrolumineszenzanordnung 10 die Funktion einer Anzeige erfüllen soll, können im Schichtverbund graphische Elemente (Schriften, Pfeile oder dgl.) ausgebildet sein, die entsprechende Informationen vermitteln. Die graphischen Elemente können durch eine geeignete Strukturierung einer oder mehrerer der Schichten 12,..,14 gebildet werden. Es ist aber auch denkbar, weitere Schichten, z.B. Abdeckschichten oder dgl., einzuführen, die ausschliesslich zur Ausbildung der graphischen Elemente vorgesehen sind.

Im Rahmen der Erfindung ist es auch denkbar, gemäss Fig. 2 den Hilfsträger 11 zunächst mit einer zusätzlichen Schicht, insbesondere Trennschicht 16 zu versehen (Fig. 2a), bevor in den weiteren Schritten (Fig. 2b-2e) die gleichen Massnahmen durchgeführt werden, wie sie im Zusammenhang mit den Fig. 1b-1e weiter oben bereits erläutert worden sind. Die Trennschicht 16 kann beim Abtrennen des Hilfsträgers 11 mit dem Hilfsträger 11 zusammen entfernt werden (Fig. 2f). Es entsteht dann die bereits bekannte Elektrolumineszenzanordnung 10.

Es ist aber auch denkbar, die zusätzliche Schicht bzw. Trennschicht 16 beim. Abtrennen des Hilfsträgers 11 als (z.B. elektrisch isolierende) Abdeckschicht auf der Schichtanordnung 12,..,14 zu belassen (Fig. 2g). Es entsteht dann die Elektrolumineszenzanordnung 10', deren erste Elektrodenschicht 12 nach aussen abgedeckt ist. Die zusätzliche Schicht kann aber auch Hafteigenschaften haben, die zum Tragen kommen, wenn die Schichtanordnung 12,..,14 auch auf dieser Seite mit einem Substrat verbunden werden soll.

Weiterhin ist es denkbar, gemäss Fig. 3 analog zu den Fig. 1a-1d zunächst die Schichtenfolge 12,..,14 auf den Hilfsträger 11 aufzubringen (Fig. 3a-3d), dann jedoch auf die zweite Elektrodenschicht 14 eine Isolier-/Haftschicht 17 aufzutragen, die zwischen der zweiten Elektrodenschicht 14 und dem Substrat 15 haftvermittelnd und/oder isolierend wirken kann (Fig. 3e). Daraus resultiert die Elektrolumineszenzanordnung 10" (Fig. 3f).

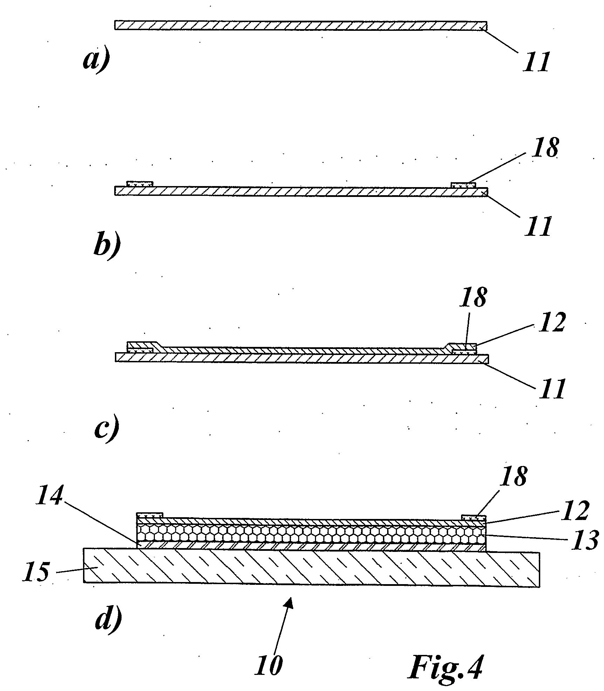

Die optisch transparente Elektrodenschicht der Schichtanordnung 12,..,14, also beispielsweise die erste Elektrödenschicht 12, wird vorzugsweise mit einer sehr geringen Dicke von etwa 5 µm aufgebracht. Um in diesem Fall bei der späteren Kontaktierung der Elektrodenschicht einen sicheren und dauerhaften Kontakt zu ermöglichen, wird auf der Elektrodenschicht in ausgewählten Bereichen eine elektrisch gut leitende Verstärkungsschicht angeordnet, wie dies in Fig. 4 am Beispiel der ersten Elektrodenschicht 12 veranschaulicht ist. Gemäss Fig. 4a und 4b wird zunächst auf den Hilfsträger die Verstärkungsschicht 18 aufgetragen, deren Dicke in der gleichen Grössenordnung liegt, wie die Dicke der ersten Elektrodenschicht. Die Verstärkungsschicht 18 ist im Beispiel als ringförmiger, die ganze Fläche umfassender "bus bar" ausgebildet, um die gesamte Fläche der ersten Elektrodenschicht 12 gleichmässig und mit geringem Widerstand kontaktieren zu können.

Anschliessend wird (Fig. 4c) die erste Elektrodenschicht 12 aufgedruckt und dann weiter gemäss den Schritten aus Fig. 1c bis 1f verfahren, um schliesslich bei der in Fig. 4d gezeigten Elektrolumineszenzanordnung 10 mit der auf der transparenten Frontelektrode (Elektrodenschicht 12) aufgebrachten Verstärkungsschicht 18 zu enden.

Es wurde bereits weiter oben darauf hingewiesen, dass die Elektrolumineszenzanordnung sich durch eine besonders hohe Biegsamkeit und eine gute Dehnbarkeit auszeichnet, ohne dass sich die einzelnen Schichten voneinander lösen oder Risse entstehen. Die Dehnbarkeit der Anordnung lässt sich noch weiter erhöhen, wenn für die einzelnen Schichten eine bestimmte Materialauswahl getroffen wird.

Das Material der Frontelektrode (Elektrodenschicht 12 oder 14) kann dazu insbesondere ein elektrisch leitendes Material auf anorganischer oder organischer Basis sein, z.B. Baytron® und/oder Polyanilin und/oder Polypyrrol, welches mit hochflexiblen Bindemitteln, z. B. auf Basis PU, PMMA, PVA, modifiziert ist. Die . dielektrische Zwischenschicht 13 kann dann beispielsweise aus einer Mischung von ZnS, BaTiO3 und den erwähnten hochflexiblen Bindemitteln bestehen. Das Material der Rückelektröde (Elektrodenschicht 14 öder 12) kann dann ein elektrisch leitendes Material auf anorganischer oder organischer Basis sein, z. B. Baytron® und/oder Polyanilin und/oder Polypyrrol, wiederum modifiziert mit hochflexiblen Bindemitteln, z. B. auf Basis PU, PMMA, PVA. Zwecks Verbesserung der elektrischen Leitfähigkeit kann das Material dieser Elektrodenschicht 14 oder 12 mit Silber oder Kohlenstoff versetzt und/oder mit einer Lage aus diesen Materialien ergänzt sein.

Die vorstehend beschriebene Zusammensetzung der einzelnen Schichten 12 bis 14 gewährleistet nicht nur die unverrückbare Haftung der genannten Schichten aufeinander, sondern auch eine bislang nicht erreichbare Dehnfähigkeit der genannten Schichten von bis zu 100%.

### BEZUGSZEICHENLISTE

- 10,10',10": Elektrolumineszenzanordnung
- 11: Hilfsträger
- 12,14: Elektrodenschicht
- 13: dielektrische Zwischenschicht (optisch aktiv)
- 13a: dielektrische Schicht
- 13b: Elektrolumineszenzschicht
- 15: Substrat
- 16: Trennschicht
- 17: Isolier-/Haftschicht
- 18: Verstärkungsschicht

## Patentansprüche

1. Verfahren zum Herstellen einer Elektrolumineszenzanordnung (10, 10', 10"), welche eine auf einem Substrat (15) angeordnete Schichtenfolge (12, 13, 14) mit zwei Elektrodenschichten (12, 14) und einer zwischen den Elektrodenschichten (12, 14) liegenden, optisch aktiven, dielektrischen Zwischenschicht (13) umfasst, wobei in einem ersten Schritt die Schichtenfolge (12, 13, 14) auf einen mit oder ohne eine Trennschicht (16) versehenen Hilfsträger (11) mittels eines Druckverfahrens aufgebracht wird, in einem zweiten Schritt die auf dem Hilfsträger (11) befindliche Schichtenfolge (12, 13, 14) mit der dem Hilfsträger (11) abgewandten Seite auf das Substrat (15) haftend aufgebracht wird, und in einem dritten Schritt der Hilfsträger (11) von der auf dem Substrat (15) haftenden Schichtenfolge (12, 13, 14) abgelöst wird, **dadurch gekennzeichnet, dass** innerhalb des ersten Schritts nacheinander die erste Elektrodenschicht (12), die Zwischenschicht (13) und die zweite Elektrodenschicht (14) direkt auf den Hilfsträger (11) bzw. die Trennschicht (16) aufgebracht werden, und dass im dritten Schritt im Falle der Trennschicht (16) die Trennschicht (16) beim Ablösen des Hilfsträgers (11) auf dem Hilfsträger (11) verbleibt.

2. Verfahren nach Anspruch 1, **dadurch gekennzeichnet, dass** die Schichten der Schichtenfolge (12, 13, 14) mittels Siebdruck auf den Hilfsträger (11) bzw. die Trennschicht (16) aufgedruckt werden.

3. Verfahren nach Anspruch 1 oder 2, **dadurch gekennzeichnet, dass** zur Bildung der optisch aktiven, dielektrische Zwischenschicht (13) wenigstens eine dielektrische Schicht (13a) und eine Elektrolumineszenzschicht (13b) in dieser oder umgekehrter Reihenfolge auf den Hilfsträger (11) bzw. die Trennschicht (16) aufgebracht werden.

4. Verfahren nach Anspruch 1 oder 2, **dadurch gekennzeichnet, dass** zur Bildung der optisch aktiven, dielektrischen Zwischenschicht (13) ein dielektrisches Material mit darin eingebetteten, zur Elektrolumineszenz anregbaren Einschlüssen auf den Hilfsträger (11) bzw. die Trennschicht (16) aufgebracht werden.

5. Verfahren nach einem der Ansprüche 1 bis 4, **dadurch gekennzeichnet, dass** die erste und/oder zweite der beiden Elektrodenschichten (12, 14) als optisch transparente Elektrode ausgebildet wird.

6. Verfahren nach Anspruch 5, **dadurch gekennzeichnet, dass** zur besseren Kontaktierung die als transparente Elektrode ausgebildete Elektrodenschicht (12, 14) in ausgewählten Bereichen mit einer leitenden Verstärkungsschicht (18) verstärkt wird.

7. Verfahren nach einem der Ansprüche 1 bis 6, **dadurch gekennzeichnet, dass** zur Isolierung und/oder besseren Haftung der Schichtenfolge (12, 13, 14) auf dem Substrat (15) zwischen der Schichtenfolge (12, 13, 14) und dem Substrat (15) eine Isolier-/Haftschicht (17) eingebracht wird, und dass die Isolier/Haftschicht (17) vor dem zweiten Schritt auf die zweite Elektrodenschicht (14) aufgebracht wird.

8. Verfahren nach einem der Ansprüche 1 bis 7, **dadurch gekennzeichnet, dass** zum Aufbau wenigstens einer der Elektrodenschichten (12, 14) leitfähige organische Materialien, insbesondere leitfähige Polymere, verwendet werden.

9. Verfahren nach einem der Ansprüche 1 bis 7, **dadurch gekennzeichnet, dass** zum Aufbau wenigstens einer der Elektrodenschichten (12, 14) leitfähige anorganische Stoffe aus der Reihe Silber, Kohlenstoff, Indium-ZinnOxid (ITO), Pigmente auf Glimmerbasis mit leitfähiger Umhüllung (Minatec(R)), verwendet werden.

10. Verfahren nach einem der Ansprüche 1 bis 9, **dadurch gekennzeichnet, dass** als Substrat (15) ein Material aus der Reihe Holz, Gewebe, insbesondere Wolle oder Baumwolle, Metall, Kunststoff, insbesondere PVC, Polyamid, Polyester, Polystyren, PP; PUR, PE, Polycarbonat, ABS, PMMA, Gummi, Papier, Leder, Kork und Glas verwendet wird.

11. Verfahren nach einem der Ansprüche 1 bis 10, **dadurch gekennzeichnet, dass** im zweiten Schritt der darin gebildete Verbund aus der Schichtenfolge (12, 13, 14) und dem Substrat (15) gleichzeitig dreidimensional verformt wird.

## Claims

1. Method for producing an electroluminescence apparatus (10, 10', 10"), which comprises a layer sequence (12, 13, 14) arranged on a substrate (15) and having two electrode layers (12, 14) and an optically active dielectric intermediate layer (13) located between the electrode layers (12, 14), wherein in a first step the layer sequence (12, 13, 14) is applied to an auxiliary carrier (11), provided with or without a separating layer (16), by means of a printing process, in a second step the layer sequence (12, 13, 14) situated on the auxiliary carrier (11) is adhesively applied to the substrate (15) with the face that faces away from the auxiliary carrier (11), and in a third step the auxiliary carrier (11) is detached from the layer sequence (12, 13, 14) bonded to the substrate (15),
**characterized in that**
within the first step the first electrode layer (12), the intermediate layer (13) and the second electrode layer (14) are applied directly to the auxiliary carrier (11) or the separating layer (16) one after another, and that in the third step in the case of the separating layer (16), the separating layer (16) remains on the auxiliary carrier (11) when the auxiliary carrier (11) is detached.

2. Method according to Claim 1,
**characterized in that**
the layers of the layer sequence (12, 13, 14) are imprinted on the auxiliary carrier (11) or the separating layer (16) by means of screen printing.

3. Method according to Claim 1 or 2,
**characterized in that**
in order to form the optically active dielectric intermediate layer (13) at least one dielectric layer (13a) and one electroluminescent layer (13b) are applied in this or the reverse order to the auxiliary carrier (11) or the separating layer (16).

4. Method according to Claim 1 or 2,
**characterized in that**
in order to form the optically active dielectric intermediate layer (13), a dielectric material with inclusions embedded therein that can be excited into electroluminescence is applied to the auxiliary carrier (11) or the separating layer (16).

5. Method according to any one of Claims 1 to 4,
**characterized in that**
the first and/or second of the two electrode layers (12, 14) is implemented as an optically transparent electrode.

6. Method according to Claim 5,
**characterized in that**
to provide better contacting the electrode layer (12, 14) which is implemented as a transparent electrode is reinforced in selected regions with a conductive reinforcement layer (18).

7. Method according to any one of Claims 1 to 6,
**characterized in that**
in order to insulate and or to provide better adhesion of the layer sequence (12, 13, 14) to the substrate (15), an insulating/bonding layer (17) is inserted between the layer sequence (12, 13, 14) and the substrate (15), and that the insulating/bonding layer (17) is applied to the second electrode layer (14) before the second step.

8. Method according to any one of Claims 1 to 7,
**characterized in that**
in order to assemble at least one of the electrode layers (12, 14), conductive organic materials are used, in particular conductive polymers.

9. Method according to any one of Claims 1 to 7,
**characterized in that**
in order to assemble at least one of the electrode layers (12, 14), conductive inorganic materials from the series silver, carbon, indium-tin oxide (ITO), and pigments based on mica with a conductive coating (Minatec(R)) are used.

10. Method according to any one of Claims 1 to 9,
**characterized in that**
as the substrate (15) a material from the series wood, woven fabric, in particular wool or cotton, metal, plastic, in particular PVC, polyamide, polyester, polystyrene, PP; PUR, PE, polycarbonate, ABS, PMMA, rubber, paper, leather, cork and glass is used.

11. Method according to any one of Claims 1 to 10,
**characterized in that**
in the second step the composite formed therein consisting of the layer sequence (12, 13, 14) and the substrate (15) is deformed in three dimensions at the same time.

## Revendications

1. Procédé pour fabriquer un système électroluminescent (10,10',10"), lequel comprend une succession de couches (12,13,14) disposée sur un substrat (15) avec deux couches d'électrodes (12,14) et une couche intermédiaire (13) diélectrique, optiquement active, située entre les couches d'électrodes (12,14), la succession de couches (12,13,14) étant appliquée dans une première étape sur un support auxiliaire (11) doté d'une ou sans couche de séparation (16) au moyen d'un procédé d'impression, dans une deuxième étape la succession de couches (12,13,14) se trouvant sur le support auxiliaire (11) étant appliquée de façon adhésive au substrat (15) avec le côté oppose au support auxiliaire (11) et dans une troisième étape, le support auxiliaire (11) étant détaché de la succession de couches (12,13,14) adhérant au substrat (15), **caractérisé en ce que** dans la première étape, la première couche d'électrodes (12), la couche intermédiaire (13) et la deuxième couche d'électrodes (14) sont appliquées l'une derrière l'autre directement sur le support auxiliaire (11) ou la couche de séparation (16) et **en ce que** dans la troisième étape en cas de couche de séparation (16), la couche de séparation (16) reste sur le support auxiliaire (11) lors du détachement du support auxiliaire (11).

2. Procédé selon la revendication 1, **caractérisé en ce que** les couches de la succession de couches (12,13,14) sont surimprimées au moyen de sérigraphie sur le support auxiliaire (11) ou la couche de séparation (16).

3. Procédé selon la revendication 1 ou 2, **caractérisé en ce que** pour former la couche intermédiaire diélectrique, optiquement active (13) au moins une couche diélectrique (13a) et une couche électroluminescente (13b) est appliquée dans cet ordre ou inversement sur le support auxiliaire (11) ou la couche de séparation (16).

4. Procédé selon la revendication 1 ou 2, **caractérisé en ce que** pour former la couche intermédiaire diélectrique, optiquement active (13), un matériau diélectrique avec des inclusions encastrées dedans activables pour electroluminescence, sont appliqués sur le support auxiliaire (11) ou la couche de separation (16) .

5. Procédé selon l'une quelconque des revendications 1 à 4, **caractérisé en ce que** la première et/ou deuxième des deux couches électroluminescentes (12,14) est constituée en tant qu'électrode optiquement transparente.

6. Procédé selon la revendication 5, **caractérisé en ce que** pour un meilleur contact, la couche d'électrodes (12, 14) constituée comme électrode transparente est renforcée dans des zones sélectionnées avec une couche de renfort conductrice (18).

7. Procédé selon l'une quelconque des revendications 1 à 6, **caractérisé en ce que** pour isoler et/ou mieux faire adhérer la succession de couches (12,13,14) sur le substrat (15), une couche isolante/adhésive (17) est insérée entre la succession de couches (12,13,14) et le substrat (15) et **en ce que** la couche isolante/adhésive (17) est appliquée avant la deuxième étape sur la deuxième couche d'électrodes (14).

8. Procédé selon l'une quelconque des revendications 1 à 7, **caractérisé en ce que** pour structurer au moins une des couches d'électrodes (12,14), on utilise des matériaux organiques conducteurs, notamment des polymères conducteurs.

9. Procédé selon l'une quelconque des revendications 1 à 7, **caractérisé ce que** pour structurer au moins une des couches d'électrodes (12, 14), on utilise des matières minérales conductrices de la série : argent, carbone, oxyde d'indium étain (ITO), pigments à base de mica avec enveloppe conductrice (Minatec(R)).

10. Procédé selon l'une quelconque des revendications 1 à 9, **caractérisé en ce qu'**en tant que substrat (15), on utilise un matériau de la série: bois, tissue, notamment laine ou coton, métal, matière plastique, notamment polychlorure de vinyle (PCV), polyamide, polyester, polystyrène, polypropylène (PP), polyuréthane (PUR), polyéthylène (PE), polycarbonate, acrylonitrile-butadiène-styrène (ABS), polyméthacrylate de méthyle (PMMA), caoutchouc, papier, cuir, liège et verre.

11. Procédé selon l'une quelconque des revendications 1 à 10, **caractérisé en ce que** dans la deuxième étape, le matériau composite formé dans celle-ci est déformé simultanément de façon tridimensionnelle à partir de la succession de couches (12,13,14) et du substrat (15).
